# EUROPÄISCHE PATENTSCHRIFT

(11) **EP 2 488 603 B1**
(45) Veröffentlichungstag und Bekanntmachung des Hinweises auf die Patenterteilung: **08.01.2014**
(21) Anmeldenummer: 10752732.7
(22) Anmeldetag: 10.09.2010
(51) Int. Cl.: C09K 11/59, H01L 51/50

(54) **LEUCHTSTOFFMISCHUNGEN MIT EUROPIUM DOTIERTEN ORTHO-SILIKATEN**
LUMINOPHORE MIXTURES HAVING EUROPIUM-DOPED ORTHOSILICATES
MÉLANGE DE SUBSTANCES LUMINESCENTES AVEC DES ORTHOSILICATES DOPÉS À L'EUROPIUM

(30) Priorität: 13.10.2009 EP 09012949; 13.10.2009 KR 20090097454; 24.12.2009 KR 20090130946
(43) Veröffentlichungstag der Anmeldung: 22.08.2012
(73) Patentinhaber: Merck Patent GmbH, 64293 Darmstadt (DE)
(72) Erfinder: WINKLER, Holger, 64291 Darmstadt (DE); BENKER, Andreas, 64686 Lautertal (DE); HUEBER, Martina, 64342 Seeheim-Jugenheim (DE); KURSAWE, Monika, 64342 Seeheim-Jugenheim (DE); PETRY, Ralf, 64347 Griesheim (DE); TEWS, Stefan, 17489 Greifswald (DE); VOSGROENE, Tim, 64372 Ober-Ramstadt (DE)
(74) Vertreter: Breuning, Esther
(86) Internationale Anmeldenummer: PCT/EP2010/005570
(87) Internationale Veröffentlichungsnummer: WO 2011/044974

(56) Entgegenhaltungen:
- US-A1- 2004 104 391
- US-A1- 2005 082 574
- US-A1- 2007 090 381
- YOO J S ET AL: "Control of spectral properties of strontium-alkaline Earth-silicate-europium phosphors for LED applications", JOURNAL OF THE ELECTROCHEMICAL SOCIETY ELECTROCHEM. SOC. USA, Bd. 152, Nr. 5, 1. April 2005 (2005-04-01) , Seiten G382-G385, XP002616649, ISSN: 0013-4651, DOI: DOI:10.1149/1.1888365

## Beschreibung

### Gebiet der Efindung

Die Erfindung betrifft neue Leuchtstoffmischungen enthaltend mindestens einen Silicat-Leuchtstoff. Die Erfindung betrifft weiterhin die Verwendung dieser Mischungen in elektronischen und elektrooptischen Vorrichtungen, insbesondere in Leuchtdioden (light emitting diodes - LEDs). Die Erfindung betrifft weiterhin die Leuchtstoffe enthaltende LEDs.

### Hintergrund und Stand der Technik

LEDs gewinnen zunehmend an Bedeutung bei der Verwendung als Hintergrundbeleuchtung in Flüssigkristall-Displays (FK-Displays). Diese neuartigen Lichtquellen weisen gegenüber den herkömmlichen Kaltkathodenfluoreszenzlampen (cold cathode fluorescence lamps - CCFL) mehrere Vorteile auf, wie längere Lebensdauer, potentielle Energieersparnis, Abwesenheit schädlicher Inhaltsstoffe (wie Quecksilber in CCFL).
In der Vergangenheit wurden Anordnungen aus LEDs, die blaues, grünes und rotes Licht emittieren, als Hintergrundbeleuchtungsquelle für FK-TV-Anwendungen eingesetzt. Dieser Multi-Chip-Ansatz hat jedoch einige Nachteile: es ist ausgesprochen schwierig, drei verschiedene Chipmaterialien zu kombinieren und Einheitlichkeit und Stabilität der Lichtparameter wie Farbpunkt sicherzustellen.
Es wurden daher pcLEDs ("phosphor converted LEDs") als Lichtquellen für die Verwendung als Hintergrundbeleuchtung eingeführt. Diese enthalten üblicherweise einen grünen Leuchtstoff und einen tiefroten Leuchtstoff zusammen mit der blauen Lichtemission eines LED-Chips, die entsprechend den Transmissionsspektren des Farbfilters (Transmissionsbanden im blauen, grünen und roten Bereich des Spektrums) angeglichen sind. Theoretisch ermöglicht ein derartiger Aufbau Farbräume, die viel größer als der übliche sRGB sind. Aufgrund von Engpässen in der Verfügbarkeit geeigneter Qualitäten besteht noch immer Bedarf an weiteren optimierten Leuchtstoffen und/oder Leuchtstoff-Gemischen mit guten Farbräumen. Überraschenderweise wurde nun gefunden, dass sich ein ausreichender Farbraum für die Anwendung in Hintergrundbeleuchtungen auch durch LEDs erzielen lässt, die eine Leuchtstoffmischung enthalten, die drei oder mehr Silicat-Leuchtstoffe der Formel I

Ba_{w}SrₓCa_{y}SiO₄: zEu (I),

worin alle Indices w, x, y und z voneinander unabhängig sind, mit der Bedingung, dass sich innerhalb einer Verbindung die Indices w, x, y und z zu 2 addieren

(w+x+y+z = 2),

und worin ein oder mehrere Silicat-Leuchtstoffe grünes, ein oder mehrere Silicat-Leuchtstoffe gelbes und ein oder mehrere Silicat-Leuchtstoffe orangefarbenes Licht emittieren und worin das Gewichtsverhältnis von grünem Leuchtstoff zu gelbem Leuchtstoff zu orangefarbenem Leuchtstoff 1,8 - 4,0 : 0,1 - 4,0 : 0,8 - 3,0 beträgt, enthält,
und worin
- es sich bei dem grün emittierenden Leuchtstoff um Ba_{w1}Srₓ₁SiO₄: z1 Eu handelt, wobei w1 = 0,80 bis 1,85; x1 = 0,10 bis 1,25 und z1 = 0,05 bis 0,20,
- es sich bei dem gelb emittierenden Leuchtstoff um Ba_{w2}Srₓ₂Ca_{y2}SiO₄: z2 Eu handelt, wobei w2 = 0,10 bis 0,80; x2 = 1,0 bis 1,80; y2 = 0,0 bis 0,2 und z2 = 0,05 bis 0,20,
- es sich bei dem orangefarben emittierenden Leuchtstoff um Ba_{w3}Srₓ₃Ca_{y3}SiO₄: z3Eu handelt, wobei w3 = 0,03 bis 0,10; x3 = 0,90 bis 1,50; y3 = 0,20 bis 0,80 und z3 = 0,05 bis 0,20.

Eine erste Ausführungsform der vorliegenden Erfindung ist daher eine Leuchtstoffmischung enthaltend drei oder mehr Silicat-Leuchtstoffe der Formel I

Ba_{w}SrₓCa_{y}SiO₄: zEu (I),

worin alle Indices w, x, y und z voneinander unabhängig sind, mit der Bedingung, dass sich innerhalb einer Verbindung die Indices w, x, y und z zu 2 addieren

(w+x+y+z = 2),

und worin ein oder mehrere Silicat-Leuchtstoffe grünes, ein oder mehrere Silicat-Leuchtstoffe gelbes und ein oder mehrere Silicat-Leuchtstoffe orangefarbenes Licht emittieren und worin das Gewichtsverhältnis von grünem Leuchtstoff zu gelbem Leuchtstoff zu orangefarbenem Leuchtstoff 1.8 - 4,0 : 0,1 - 4,0 : 0,8 - 3,0 beträgt,
und worin
- es sich bei dem grün emittierenden Leuchtstoff um Ba_{w1}Srₓ₁SiO₄: z1 Eu handelt, wobei w1 = 0,80 bis 1,85; x1 = 0,10 bis 1,25 und z1 = 0,05 bis 0,20,
- es sich bei dem gelb emittierenden Leuchtstoff um Ba_{w2}Srₓ₂Ca_{y2}SiO₄: z2 Eu handelt, wobei w2 = 0,10 bis 0,80; x2 = 1,0 bis 1,80; y2 = 0,0 bis 0,2 und z2 = 0,05 bis 0,20,
- es sich bei dem orangefarben emittierenden Leuchtstoff um Ba_{w3}Srₓ₃Ca_{y3}SiO₄: z3Eu handelt, wobei w3 = 0,03 bis 0,10; x3 = 0,90 bis 1,50; y3 = 0,20 bis 0,80 und z3 = 0,05 bis 0,20.

Ein ausreichender Farbraum bedeutet eine gute Abdeckung des sRGB-Bereiches; d.h. die Abdeckung des Farbraumdreiecks der Hintergrundbeleuchtungsquelle einschließlich Farbfilter im CIE 1931-Chromatizitätsdiagramm, wobei das Dreieck, das die drei sRGB-Farbpunkte nach CIE 1931 umfasst, so groß wie möglich sein sollte. Eine gute Deckung, die für TV-Anwendungen geeignet ist, erzielt man, wenn mehr als 90 % des Bereiches, vorzugsweise mehr als 95 % des Bereiches abgedeckt sind.

Orthosilicate weisen gegenüber Gemischen aus tiefroten Nitriden mehrere Vorteile auf:
Sie sind viel breiter verfügbar, weniger kostspielig und sie ermöglichen eine Angleichung ihres Fluoreszenzbandes in sehr kleinen Schritten durch leichte Änderungen der Zusammensetzung der Elementarformel (Ca,Sr,Ba)₂₋ₓSiO₄:Euₓ. Dies ermöglicht eine optimierte Anpassung der Transmissionskurven der Farbfilter.
Insbesondere wurde überraschenderweise gefunden, dass durch Mischen mehrerer Orthosilicate, z.B. eines grünlichen Typs mit einem gelben und einem orangefarbenen Typ, die sich ergebende Mischung im Vergleich zu einem einzelnen Orthosilicat-Leuchtstoff eine breitere Bande zeigt. Eine LED mit einer breiteren Emissionsbande ist wichtig, um eine ausreichende Spektralstärke nicht nur im blauen Bereich (durch LED-Chip-Emission) und grünen Bereich (durch Leuchtstoffemission), sondern auch im roten Bereich (durch Leuchtstoffemission) sicherzustellen.

WO 02/054502 beschreibt eine Leuchtstoffmischung mit zwei oder drei Leuchtstoffen, vorzugsweise zwei Silicat-Leuchtstoffen und einem weiteren Leuchtstoff (Barium-Magnesium-Aluminat oder Strontium-Magnesium-Aluminat:Eu).

WO 2007/018569 beschreibt eine Leuchtstoffzusammensetzung mit minmindestens zwei Phasen auf Silicatbasis enthaltend eine erste Phase mit einer Kristallstruktur, die im Wesentlichen der von (Ca,Sr,Ba,Mg,Zn)₂SiO₄ entspricht, und einer zweiten Phase mit einer Kristallstruktur, die im Wesentlichen der von (Ca,Sr,Ba,Mg,Zn)₃SiO₅ entspricht, wobei mindestens eine Phase der Zusammensetzung Mg und mindestens eine der Phasen der Zusammensetzung einen Dotierstoff F, Cl, Br, S oder N enthält.

KR-2005-23990 beschreibt eine LED mit einer Pressharzschicht enthaltend eine auf gelb, grün und orangefarben aufbauende Leuchtstoffmischung mit einem Mengenverhältnis im Bereich von 70 : 20 : 10 bis 95 : 4 : 1, vorzugsweise 75 : 16,8 : 8,2 oder 80 : 13,6 : 6,4, in der mindestens ein Leuchtstoff auf Orthosilicatbasis verwendet wird. Der gelbe Leuchtstoff bildet den Hauptbestandteil des Gemisches.

Aus US 2007/090381 A1 ist eine Leuchtstoffmischung bekannt, welche einen gelben, einen orangefarbenen und einen grünen Silicat-Leuchtstoff enthält. Ein Leuchtstoffverhältnis von grünem zu gelbem und orangefarbenem Leuchtstoff ist nicht angegeben.

US 2004/104391 A1 sind orange und grün emittierende Silicat-Leuchtstoffe bekannt. Eine Leuchtstoffmischung aus einem gelben, einem orangefarbenen und einem grünen Silicat-Leuchtstoff ist nicht offenbart.

### Ausführliche Beschreibung der Erfindung

Die Erfindung betrifft eine Leuchtstoffmischung enthaltend drei oder mehr Silicat-Leuchtstoffe der Formel I

Ba_{w}SrₓCa_{y}SiO₄: zEu (I),

worin alle Indices w, x, y und z voneinander unabhängig sind, mit der Bedingung, dass sich innerhalb einer Verbindung die Indices w, x, y und z zu 2 addieren

(w+x+y+z = 2),

und worin ein oder mehrere Silicat-Leuchtstoffe grünes, ein oder mehrere Silicat-Leuchtstoffe gelbes und ein oder mehrere Silicat-Leuchtstoffe orange farbenes Licht emittieren und worin das Gewichtsverhältnis von grünem Leuchtstoff zu gelbem Leuchtstoff zu orangefarbenem Leuchtstoff 1,8 - 4,0 : 0,1 - 4,0 : 0,8 - 3,0, vorzugsweise 1,8 - 2,5 : 0,8 - 1,3 : 1,8 - 2,5 beträgt, und worin
- es sich bei dem grün emittierenden Leuchtstoff um Ba_{w1}Srₓ₁SiO₄: z1 Eu handelt, wobei w1 = 0,80 bis 1,85; x1 = 0,10 bis 1,25 und z1 = 0,05 bis 0,20,
- es sich bei dem gelb emittierenden Leuchtstoff um Ba_{w2}Srₓ₂Ca_{y2}SiO₄: z2 Eu handelt, wobei w2 = 0,10 bis 0,80; x2 = 1,0 bis 1,80; y2 = 0,0 bis 0,2 und z2 = 0,05 bis 0,20,
- es sich bei dem orangefarben emittierenden Leuchtstoff um Ba_{w3}Srₓ₃Ca_{y3}SiO₄: z3Eu handelt, wobei w3 = 0,03 bis 0,10; x3 = 0,90 bis 1,50; y3 = 0,20 bis 0,80 und z3 = 0,05 bis 0,20.

Die Erfindung betrifft weiterhin das Verfahren zur Herstellung der erfindungsgemäßen Leuchtstoffmischung, bei dem man einen ersten Silicat-Leuchtstoff mit einem oder mehreren weiteren Leuchtstoffen mischt.

Die Leuchtstoffe sind gut bekannte Verbindungen und können nach herkömmlichen Verfahren über Festkörperdiffusionssynthese oder auch durch nasschemische Verfahren hergestellt werden (siehe William M. Yen, Marvin J. Weber, Inorganic Phosphors, Compositions, Preparation and optical properties, CRC Press, New York, 2004 oder WO 02/054502).

Ein weiterer Gegenstand der vorliegenden Erfindung ist eine Lichtquelle, welche einen IndiumAluminiumGalliumNitrid-Halbleiter und eine erfindungsgemäße Leuchtstoffmischung enthält.

Der IndiumAluminiumGalliumNitrid-Halbleiter weist typischerweise die Formel InᵢGaⱼAlₖN auf, wobei 0 ≤ i, 0 ≤ j, 0 ≤ k und I + j + k = 1.

Bei der Lichtquelle handelt es sich vorzugsweise um eine Leuchtdiode (LED) oder eine LED-Hintergrundbeleuchtung für Display-Anwendungen mit einer blau emittierenden InGaN-Halbleiterdiode, die zusammen mit entsprechenden Konversionsleuchtstoffen und vorzugsweise weißes oder nahezu weißes Licht emittiert. Diese InGaN-Halleiterdiode weist typischerweise ein Emissionsmaximum zwischen 430 nm und 480 nm auf und zeigt sehr hohe Effizienz und vorzugsweise eine lange Lebensdauer mit nur sehr geringer Abnahme der Effizienz.

Vorzugsweise könnte die Leuchtstoffschicht (Leuchtstoffmischung) direkt auf der Oberfläche des Chips angeordnet sein oder könnte in einem spezifischen Volumen direkt über dem und/oder um den Chip verteilt sein oder könnte in einer Schicht oder einem Volumen in einem spezifischen Abstand vom Chip angeordnet sein ("remote phosphor").

Ein weiterer Gegenstand der vorliegenden Erfindung ist ein Hintergrundbeleuchtungssystem mit mindestens einer Lichtquelle gemäß der vorliegenden Erfindung.
Das erfindungsgemäße Hintergrundbeleuchtungssystem kann beispielsweise ein "Direct-Lit"-Hintergrundbeleuchtungssystem oder ein "Side-Lit"-Hintergrundbeleuchtungssystem, welches einen Lichtleiter und eine Auskoppelstruktur aufweist, sein.
Das Hintergrundbeleuchtungssystem weist eine weiße Lichtquelle auf, die sich meist in einem Gehäuse befindet, welches vorzugsweise auf der Innenseite einen Reflektor aufweist. Das Hintergrundbeleuchtungssystem kann weiterhin mindestens eine Diffusorplatte aufweisen.
Zur Erzeugung und Darstellung von farbigen Bildern wird die Flüssigkristalleinheit mit einem Farbfilter versehen. Der Farbfilter enthält mosaikartig gemusterte Pixel, die entweder rotes, grünes oder blaues Licht durchlassen. Der Farbfilter ist vorzugsweise zwischen dem ersten Polarisator und der Flüssigkristallzelle angeordnet.

Gegenstand der vorliegenden Erfindung ist weiterhin ein Flüssigkristall-Display ausgestattet mit mindestens einem Hintergrundbeleuchtungssystem mit mindestens einer weißen Lichtquelle, welche mindestens eine Halbleiterdiode, vorzugsweise blau emittierend, und mindestens eine Leuchtstoffschicht enthaltend eine Leuchtstoffmischung wie oben definiert enthält.
Ein Flüssigkeitskristall-Display weist üblicherweise eine Flüssigkristalleinheit und ein Hintergrundbeleuchtungssystem auf. Die Flüssigkristalleinheit umfasst typischerweise einen ersten und einen zweiten Polarisator sowie eine Flüssigkristallzelle, welche zwei transparente Schichten aufweist, die jeweils eine Matrix aus lichtdurchlässigen Elektroden tragen. Zwischen den beiden Substraten ist ein Flüssigkristallmaterial angeordnet. Das Flüssigkristallmaterial enthält z.B. TN (twisted nematic)-Flüssigkristalle, STN (super twisted nematic)-Flüssigkristalle, DSTN (double super twisted nematic)-Flüssigkristalle, FSTN (foil super twisted nematic)-Flüssigkristalle, VAN (vertically aligned nematic)-Flüssigkristalle oder OCB (optically compensated bend)-Flüssigkristalle. Die Flüssigkristallzelle ist sandwichartig von den zwei Polarisatoren, wobei der zweite Polarisator vom Betrachter gesehen werden kann, umschlossen.

Auch für Monitoranwendungen sehr gut geeignet ist die IPS-Technologie (In Plane Switching). Im Gegensatz zum TN-Display befinden sich bei der IPS-Zelle die Elektroden, in deren elektrischem Feld die Flüssigkristallmoleküle geschaltet werden, nur auf einer Seite der Flüssigkristallschicht. Das resultierende elektrische Feld ist inhomogen und in erster Näherung parallel zur Substratoberfläche ausgerichtet. Die Moleküle werden entsprechend in der Substratebene geschaltet ("in plane"), was im Vergleich zum TN=Display zu einer deutlich geringeren Blickwinkelabhängigkeit der transmittierten Intensität führt.
Eine weitere, nicht so bekannte Technik für gute optische Eigenschaften über einen weiten Betrachtungswinkel ist die FFS-Technologie und eine Weiterentwicklung hiervon, die AFFS-Technologie ("advanced fringe field switching"). Sie hat ein ähnliches Funktionsprinzip wie die IPS-Technologie.

Ein weiterer Aspekt der vorliegenden Erfindung betrifft eine elektronische oder elektrooptische Vorrichtung enthaltend eine oder mehrere Leuchtstoffmischungen wie vor- und nachstehend beschrieben. Ein weiterer Aspekt betrifft die Verwendung der Leuchtstoffmischungen wie vor- und nachstehend beschrieben in einer elektronischen oder elektrooptischen Vorrichtung. Besonders bevorzugte Vorrichtungen sind LEDs für die Anwendung in Hintergrundbeleuchtungen.

Bei der elektronischen oder elektrooptischen Vorrichtung kann es sich beispielsweise auch um einen organischen Feldeffekttransistor (OFET), einen Dünnfilmtransistor (TFT), eine organische Solarzelle (O-SC), eine organische Laserdiode (O-laser), eine organische integrierte Schaltung (0-IC), ein RFID (radio frequency identification)-Tag, einen Photodetektor, einen Sensor, eine logische Schaltung, ein Speicherelement, einen Kondensator, eine Ladungsinjektionsschicht, eine Schottky-Diode, eine Planarisierungsschicht, eine Antistatikfolie, ein leitendes Substrat oder eine leitende Struktur, einen Photoleiter, ein elektrophotographisches Element oder einen organischen lichtemittierenden Transistor (organic light emitting transistor - OLET) handeln.

### Definition der Ausdrücke

Der Ausdruck "Leuchtstoffmischung" bezeichnet ein Leuchtstoff-Gemisch, in dem zwei oder mehr Leuchtstoffe miteinander vermischt werden, so dass eine neue Zusammensetzung mit unterschiedlichen physikalischen Eigenschaften entsteht.

Der Ausdruck "grün emittierender Leuchtstoff' bezeichnet einen Silicat-Leuchtstoff mit mindestens einem Emissionsmaximum zwischen 508 nm und 550 nm Wellenlänge.

Der Ausdruck "orangefarben emittierender Leuchtstoff' bezeichnet einen Silicat-Leuchtstoff mit mindestens einem Emissionsmaximum zwischen 586 nm und 625 nm Wellenlänge,

Der Ausdruck "gelb emittierender Leuchtstoff' oder "Leuchtstoff emittiert gelbes Licht" bezeichnet einen Leuchtstoff mit mindestens einem Emissionsmaximum zwischen 551 nm und 585 nm Wellenlänge.

Der Ausdruck "Festkörperdiffusionsverfahren" ("mix & fire"-Verfahren) gibt an, dass man die oxidischen Ausgangsmaterialien als Pulver mischt, das Gemisch mahlt und die gemahlenen Pulver dann bis zu mehreren Tagen in einem Ofen bei Temperaturen bis zu 1500° C in einer gegebenenfalls reduzierenden Atmosphäre kalziniert.

Der Ausdruck "nasschemische Verfahren" gemäß der Erfindung umfasst vorzugsweise drei Verfahrensvarianten:
- In der ersten Verfahrensvariante wird eine organische Siliciumverbindung, vorzugsweise Si(OEt)₄, beispielsweise zu Hydroxidlösungen der entsprechenden Leuchtstoff-Ausgangsmaterialien und einem Eu-haltigen Dotierstoff bei erhöhten Temperaturen hinzugegeben, was zur Bildung des Leuchtstoff-Vorläufers führt.
- In der zweiten Verfahrensvariante, der so genannten Oxalatfällung, werden zunächst Erdalkalihalogenide mit einem Europiumhalogenid in Wasser gelöst und zu einem siliciumhaltigen Gemisch bestehend aus einer Dicarbonsäure und einer anorganischen oder organischen Siliciumverbindung hinzugegeben. Eine Erhöhung der Viskosität führt zur Bildung des Leuchtstoff-Vorläufers.
- In der dritten Verfahrensvariante, der so genannten Hydrogencarbonatfällung, werden zunächst Erdalkali-Ausgangsmaterialien, vorzugsweise Erdalkalihalogenide, mit einem europiumhaltigen Dotierstoff in Wasser gelöst und anschließend wird eine anorganische oder organische siliciumhaltige Verbindung zugegeben. Die Fällung wird mit einer Hydrogencarbonatlösung durchgeführt, was zur langsamen Bildung des Leuchtstoff-Vorläufers führt.

Abschließend ist eine thermische Nachbehandlung (Kalzinierung) des Leuchtstoff-Vorläufers notwendig, um den fertigen Silicat-Leuchtstoff zu erhalten.

Wenn der Zusammenhang nicht deutlich etwas anderes angibt, sind die hierin verwendeten Pluralformen der hierin verwendeten Ausdrücke so zu verstehen, dass sie auch die Singularform beinhalten, und umgekehrt.

Die Worte "umfassen" und "enthalten" und Variationen hiervon, beispielsweise "umfassend" und "umfasst", bedeuten in der gesamten Beschreibung und den gesamten Ansprüchen dieser Spezifikation "beinhaltend, ohne hierauf beschränkt zu sein" und sind nicht so zu verstehen, dass andere Komponenten ausgeschlossen werden oder werden sollen.

Es versteht sich, dass die vorstehenden Ausführungsformen der Erfindung variiert werden können und dabei weiterhin unter den Schutzbereich der Erfindung fallen. Jedes in dieser Spezifikation offenbarte Merkmal kann, soweit nicht anders angegeben, durch alternative Merkmale ersetzt werden, die einem gleichen, gleichwertigen oder ähnlichen Zweck dienen. Wenn nicht anders angegeben, ist dementsprechend jedes offenbarte Merkmal nur ein Beispiel einer generischen Reihe gleichwertiger oder ähnlicher Merkmale.

Die Erfindung wird nachstehend mit Bezug auf die folgenden Beispiele, die nur zur Erläuterung dienen und den Schutzumfang der Erfindung nicht einschränken, genauer beschrieben.

### Beispiel 1: Herstellung der Leuchtstoffmischung A

Die folgende Orthosilicat-Leuchtstoffmischung A wird synthetisiert, indem man die drei Orthosilicate wie folgt:
- SGA 524 100 (grüner Leuchtstoff, der bei ca. 524 nm emittiert; Quelle: Merck KGaA),
- SGA 555 100 (gelber Leuchtstoff, der bei ca. 555 nm emittiert; Quelle: Merck KGaA) und
- SGA 593 100 (orangefarbener Leuchtstoff, der bei ca. 593 nm emittiert; Quelle: Merck KGaA)
im Gewichtsverhältnis 2:1:2 mischt.

Die drei Leuchtstoffe SGA 524100, 555100 und 593100 werden vermischt, indem man die Komponenten mittels eines Rhönradmischers bei 5 Umdrehungen pro Minute mischt.

Für die allgemeinen Bedingungen der Synthese von Orthosilicat-Leuchtstoffen wird auf T.L. Barry, J. Electrochem. Soc., 1968, 11811181 und US 3505240 verwiesen. Die US 3505240 beschreibt beispielsweise den Leuchtstoff (Ba,Sr)SiO₄:Eu, der hergestellt wird, indem man Barium- und Strontiumcarbonate mit einer Quelle für SiO₂ und Eu mischt. Ein Ammoniumchloridflussmittel wird in das Gemisch eingemischt und der Ansatz geglüht, um den Leuchtstoff herzustellen. Wie aus Tabelle 1 der US 3505240 zu ersehen ist, verschiebt sich die Peak-Emission von grün (505 nm) zu gelb (575 nm), wenn man z.B. die Mengen an in die feste Lösung aufgenommenem Sr₂SiO₄ erhöht, während man die Gesamt-Molprozent an Ba₂SiO₄ und Sr₂SiO₄ bei 100 % hält. Der Fachmann leitet daher aus der Lehre von T.L. Barry, J. Electrochem. Soc., 1968, 11811181 und US 3505240 ab, wie man Silicate mit grüner, gelber oder orangefarbener Farbe herstellt.

Die verwendeten Rohmaterialien sind gemäß der vorliegenden Erfindung Erdalkalicarbonate, Europiumoxid und Ammoniumchlorid und Kieselsäure. Der Leuchtstoff wird durch trockenes Vermischen der Rohmaterialien in den erforderlichen stöchiometrischen Mengen hergestellt. Als Flussmittel wird Ammoniumchlorid zugegeben. Das Gemisch wird in einen Tonerdetiegel überführt und in einen Ofen überführt. Für den Glühprozess wird die Probe unter einer reduktiven Atmosphäre 2 bis 12 Stunden lang auf bis zu 1300°C erhitzt.

### Beispiele 2 bis 11: Herstellung der Leuchtstoffmischungen B bis M

**Tabelle 1: Zusammensetzungen verschiedener Mischungen, die sich zur Anwendung in LCD-Hintergrundbeleuchtungen eignen**

| | SGA 515 100 | SGA 524 100 | SGA 540 100 | SGA 545 100 | SGA 555 100 | SGA 565 300 | SGA 587 100 | SGA 593 100 | SGA 605 100 |
|---|---|---|---|---|---|---|---|---|---|
| **Blend B** | | | 2,2g | | | | 2g | | |
| **Blend C** | | 2g | | | | 1g | | 2g | |
| **Blend A** | | 2g | | | 1g | | | 2g | |
| **Blend D** | | 2,5g | | | | 1g | | 2g | |
| **Blend E** | | 2,5g | | | 1g | | | 2g | |
| **Blend F** | | 2g | | | 1g | 1g | 2g | | |
| **Blend G** | 2g | | | | 1g | | | 2g | |
| **Blend H** | | 2,5g | | 1g | | 1g | | | 2g |
| **Blend I** | | 2,5g | | 1,3g | | 1,2g | | | 2,2g |
| **Blend J** | 2g | | | | | | | | 1g |
| **Blend K** | | 2g | | | | | | | 2g |
| **Blend L** | | 2g | | | | 0,2g | | | 2g |
| **Blend M** | | 2,5g | | 1g | | | | 2g | |

Grüne Leuchtstoffe sind: SGA 515 100, SGA 524 100, SGA 540 100 und SGA 545 100.
Gelbe Leuchtstoffe sind: SGA 555 100, SGA 565 100, SGA 587 100.
Orangefarbene Leuchtstoffe sind: SGA 593 100 und SGA 605 100.

Die Zahlen xyz in SGA xyz 100 geben die Wellenlänge des Maximums des Emissionspeaks an.

Die Synthese der in der Tabelle 1 genannten Leuchtstoffe wird entsprechend der in Beispiel 1 beschriebenen Vorgehensweise vorgenommen. Die Leuchtstoffe werden in den in Tabelle 1 angegebenen Mengen vermischt, indem man die Komponenten mittels eines Rhönradmischers mit 5 Umdrehungen pro Minute mischt.

### Beispiel 12: Herstellung und Charakterisierung einer LED und Einbau in ein Flüssigkristall-Display

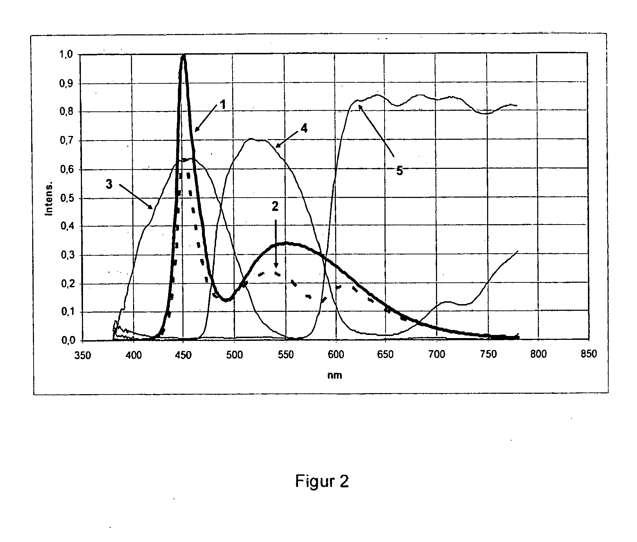

Die Leuchtstoffmischung aus Beispiel 1 wird mit einem Zweikomponenten-Silikonharzsystem (A und B) OE 6550 von Dow Corning mit Hilfe eines Taumelmischers derart gemischt, dass gleiche Mengen Leuchtstoff in der Komponente A und B dispergiert werden (Endkonzentration an Leuchtstoff im Silikon: 8 %). Jeweils 5 ml der Komponente A und 5 ml der Komponente B werden so gemischt, dass ein homogenes Gemisch entsteht, und in ein Vorratsgefäß eingebracht, das mit dem Messventil eines Dispensers verbunden ist. Roh-LED-Packages, geliefert durch OSA opto electronics, Berlin, bestehend aus gebondeten lnGaN-Chips mit einer Oberfläche von jeweils 1 mm², die bei einer Wellenlänge von 450 nm emittieren, werden im Dispenser befestigt. Die Hohlräume der Roh-LED-Packages werden mittels der xyz-Positionierung des Dispenser-Ventils mit dem Silikon-Leuchtstoff gefüllt. Die so behandelten LEDs werden dann einer Temperatur von 150°C ausgesetzt, bei der sich das Silikon verfestigt. Die LEDs können dann in Betrieb genommen werden und emittieren weißes Licht mit einer Farbtemperatur von ca. 6000 K.
Eine gebräuchliche LCD-TV-Farbfilter-Charakteristik wurde verwendet, um eine Display-Umgebung zu simulieren und den durch diese LED realisierten Farbraum zu berechnen. Die Spektren des Farbfilters, das LED-Spektrum ohne und mit Farbfilter sind in Fig. 2 angegeben. Das LED-Spektrum mit Farbfilter wurde mit einem Farbfilterblatt zwischen LED und Detektor aufgenommen. Die Charakterisierung der LED wurde unter Verwendung eines Spektrometers CAS 140 von Instruments Systems vorgenommen.

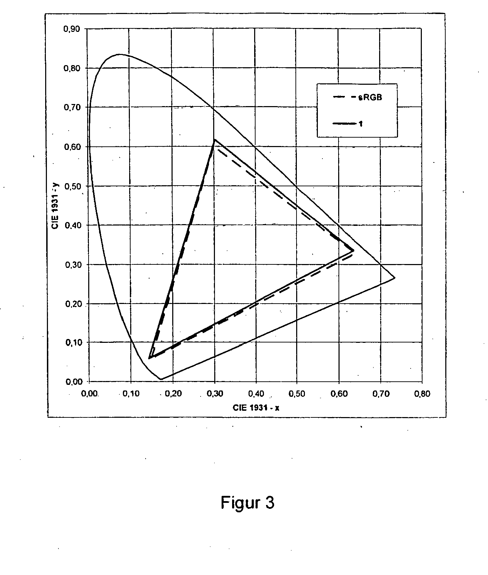

Die Farbraumdeckung der die Leuchtstoffmischung des Beispiels 1 enthaltenden LED ist in Figur 3 angegeben und errechnet sich zu ca. 98 %-iger Deckung des sRGB. Mehrere der oben hergestellten LEDs werden dann in ein Hintergrundbeleuchtungssystem eines Flüssigkristall-Displays eingebaut.

### Beispiele 13 - 23:

Die Leuchtstoffmischungen B - M aus den Beispielen 2 - 11 werden verwendet, um LEDs und FK-Displays wie in Beispiel 12 beschrieben herzustellen.

### Beschreibung der Zeichnungen

Die Erfindung wird im Folgenden unter Bezugnahme auf die beispielhaften Ausführungsformen genauer erläutert; es zeigen:

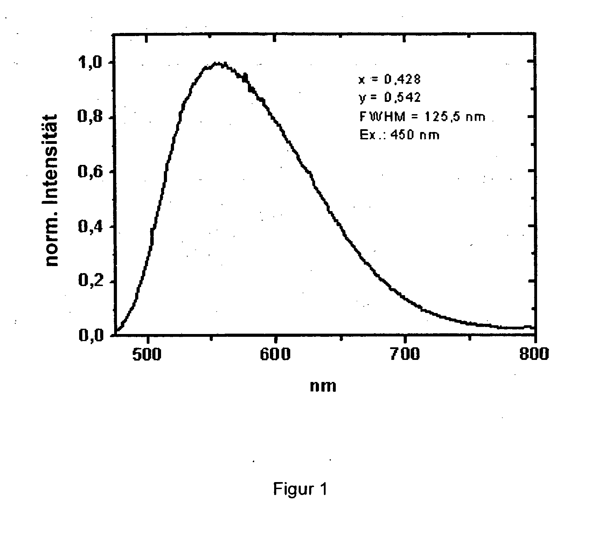

Fig. 1 ein Emissionsspektrum der Orthosilicat-Mischung A. Seine Fluoreszenzbanden-Peaks liegen bei ca. 568 nm.
Fig. 2 ein Transmissionsspektrum eines Farbfilters (3: blaue Transmissionsbande, 4: grüne Transmissionsbande, 5: rote Transmissionsbande), Emissionsspektrum der Orthosilicat-Mischung A enthaltenden LED (1: reines LED-Spektrum, 2: LED-Spektrum mit Farbfilter)
Fig. 3 die Farbraumdeckung der Orthosilicat-Mischung A enthaltenden LED in CIE 1931. Das Dreieck stellt den sRGB-Farbraum dar, während das fett dargestellte Dreieck den Farbraum angibt, der durch die Kombination eines Standard-Farbfilters (Fig.1) und einer Orthosilicat-Mischung A enthaltenden LED realisiert wird (1: Farbraum einer Orthosilicat-Mischung A enthaltenden LED; sRGB: Farbraum des sRGB)

## Patentansprüche

1. Leuchtstoffmischung enthaltend drei oder mehr Silicat-Leuchtstoffe der Formel I
Ba_{w}SrₓCa_{y}SiO₄: zEu (I),
worin alle Indizes w, x, y und z voneinander unabhängig sind, mit der Bedingung, dass sich innerhalb einer Verbindung die Indizes w, x, y und z zu 2 addieren (w+x+y+z = 2),
und worin ein oder mehrere Silicat-Leuchtstoffe grünes, ein oder mehrere Silicat-Leuchtstoffe gelbes und ein oder mehrere Silicat-Leuchtstoffe orangefarbenes Licht emittieren, wobei grüne Emission ein Emissionsmaximum zwischen 508 nm und 550 nm und gelbe Emission ein Emissionsmaximum zwischen 551 nm und 585 nm und orangefarbene Emission ein Emissionsmaximum zwischen 586 nm und 625 nm bedeutet, und worin das Gewichtsverhältnis von grünem Leuchtstoff zu gelbem Leuchtstoff zu orangefarbenem Leuchtstoff 1,8 - 4,0 : 0,1 - 4,0 : 0,8 - 3,0 beträgt;
und worin
• es sich bei dem grün emittierenden Leuchtstoff um Ba_{w1}Srₓ₁SiO₄: z1 Eu handelt, wobei w1 = 0,80 bis 1,85; x1 = 0,10 bis 1,25 und z1 = 0,05 bis 0,20,
• es sich bei dem gelb emittierenden Leuchtstoff um Ba_{w2}Srₓ₂Ca_{y2}SiO₄: z2 Eu handelt, wobei w2 = 0,10 bis 0,80; x2 = 1,0 bis 1,80; y2 = 0,0 bis 0,2 und z2 = 0,05 bis 0,20,
• es sich bei dem orangefarben emittierenden Leuchtstoff um Ba_{w3}Srₓ₃Ca_{y3}SiO₄: z3Eu handelt, wobei w3 = 0,03 bis 0,10; x3 = 0,90 bis 1,50; y3 = 0,20 bis 0,80 und z3 = 0,05 bis 0,20.

2. Leuchtstoffmischung nach Anspruch 1, worin das Gewichtsverhältnis von grünem Leuchtstoff zu gelbem Leuchtstoff zu orangefarbenem Leuchtstoff 1,8 - 2,5 : 0,8 - 1,3 : 1,8 - 2,5 beträgt.

3. Lichtquelle, welche einen IndiumAluminiumGalliumNitrid-Halbleiter und eine Leuchtstoffmischung nach Anspruch 1 oder 2 enthält.

4. Lichtquelle nach Anspruch 3, **dadurch gekennzeichnet, dass** das Gewichtsverhältnis von grünem Leuchtstoff zu gelbem Leuchtstoff zu orangefarbenem Leuchtstoff 1,8 bis 2,5 : 0,8 bis 1,3 : 1,8 bis 2,5 beträgt.

5. Hintergrundbeleuchtungssystem mit mindestens einer Lichtquelle nach den Ansprüchen 3 oder 4.

6. Flüssigkristall-Display (LCD) ausgestattet mit einem oder mehreren Hintergrundbeleuchtungssystemen nach Anspruch 5.

7. Elektronische oder elektrooptische Vorrichtung enthaltend eine Leuchtstoffmischung nach Anspruch 1 oder 2.

8. Verfahren zur Herstellung einer Leuchtstoffmischung nach Anspruch 1 oder 2, bei dem man einen ersten Silicat-Leuchtstoff mit einem oder mehreren weiteren Leuchtstoffen mischt.

## Claims

1. Phosphor mixture comprising three or more silicate phosphors of the formula I
Ba_{w}SrₓCa_{y}SiO₄: zEu (I),
in which all indices w, x, y and z are independent of one another, with the condition that within one compound the indices w, x, y and z add up to 2 (w+x+y+z = 2),
and in which one or more silicate phosphors emit green light, one or more silicate phosphors emit yellow light and one or more silicate phosphors emit orange light, where green emission denotes an emission maximum between 508 nm and 550 nm and yellow emission denotes an emission maximum between 551 nm and 585 nm and orange emission denotes an emission maximum between 586 nm and 625 nm, and in which the weight ratio of green phosphor to yellow phosphor to orange phosphor is 1.8 - 4.0 : 0.1 - 4.0 : 0.8 - 3.0;
and in which
• the green-emitting phosphor is Ba_{w1}Srₓ₁SiO₄: z1 Eu, where w1 = 0.80 to 1.85; x1 = 0.10 to 1.25 and z1 = 0.05 to 0.20,
• the yellow-emitting phosphor is Ba_{w2}Srₓ₂Ca_{y2}SiO₄: z2 Eu, where w2 = 0.10 to 0.80; x2 = 1.0 to 1.80; y2 = 0.0 to 0.2 and z2 = 0.05 to 0.20,
• the orange-emitting phosphor is Ba_{w3}Srₓ₃Ca_{y3}SiO₄: z3Eu, where w3 = 0.03 to 0.10; x3 = 0.90 to 1.50; y3 = 0.20 to 0.80 and z3 = 0.05 to 0.20.

2. Phosphor mixture according to Claim 1, in which the weight ratio of green phosphor to yellow phosphor to orange phosphor is 1.8 - 2.5 : 0.8 - 1.3 : 1.8 - 2.5.

3. Light source which comprises an indium aluminium gallium nitride semiconductor and a phosphor mixture according to Claim 1 or 2.

4. Light source according to Claim 3, **characterised in that** the weight ratio of green phosphor to yellow phosphor to orange phosphor is 1.8 to 2.5 : 0.8 to 1.3: 1.8 to 2.5.

5. Backlighting system having at least one light source according to Claims 3 or 4.

6. Liquid-crystal display (LCD) fitted with one or more backlighting systems according to Claim 5.

7. Electronic or electro-optical device comprising a phosphor mixture according to Claim 1 or 2.

8. Process for the preparation of a phosphor mixture according to Claim 1 or 2, in which a first silicate phosphor is mixed with one or more further phosphors.

## Revendications

1. Mélange de luminophores comprenant trois, ou plus, luminophores à base de silicate de formule I
Ba_{w}SrₓCa_{y}SiO₄: zEu (I),
où tous les indices w, x, y et z sont indépendants les uns des autres, à condition qu'au sein d'un composé les indices w, x, y et z totalisent 2 (w+x+y+z = 2),
et où un ou plusieurs luminophores à base de silicate émettent de la lumière verte, un ou plusieurs luminophores à base de silicate émettent de la lumière jaune et un ou plusieurs luminophores à base de silicate émettent de la lumière orange, où l'émission verte désigne un maximum d'émission compris entre 508 nm et 550 nm et l'émission jaune désigne un maximum d'émission compris entre 551 nm et 585 nm et l'émission orange désigne un maximum d'émission compris entre 586 nm et 625 nm, et où le rapport pondéral du luminophore vert au luminophore jaune au luminophore orange est de 1,8 - 4,0 : 0,1 - 4,0 : 0,8 - 3,0;
et où
• le luminophore à émission verte est Ba_{w1}Srₓ₁SiO₄: z1 Eu, où w1 = 0,80 à 1,85; x1 = 0,10 à 1,25 et z1 = 0,05 à 0,20,
• le luminophore à émission jaune est Ba_{w2}Srₓ₂Ca_{y2}SiO₄: z2 Eu, où w2 = 0,10 à 0,80; x2 = 1,0 à 1,80; y2 = 0,0 à 0,2 et z2 = 0,05 à 0,20,
• le luminophore à émission orange est Ba_{w3}Srₓ₃Ça_{y3}SiO₄: z3Eu, où w3 = 0,03 à 0,10; x3 = 0,90 à 1,50; y3 = 0,20 à 0,80 et z3 = 0,05 à 0,20.

2. Mélange de luminophores selon la revendication 1, où le rapport pondéral du luminophore vert au luminophore jaune au luminophore orange est de 1,8 - 2,5 : 0,8 - 1,3 : 1,8 - 2,5.

3. Source lumineuse comprenant un semi-conducteur à base de nitrure d'indium-aluminium-gallium et un mélange de luminophores selon la revendication 1 ou 2.

4. Source lumineuse selon la revendication 3, **caractérisée en ce que** le rapport pondéral du luminophore vert au luminophore jaune au luminophore orange est de 1,8 à 2,5 : 0,8 à 1,3 : 1,8 à 2,5.

5. Système de rétro-éclairage possédant au moins une source lumineuse selon les revendications 3 ou 4.

6. Affichage à cristaux liquides (LCD) pourvu d'un ou plusieurs systèmes de rétro-éclairage selon la revendication 5.

7. Dispositif électronique ou électro-optique comprenant un mélange de luminophores selon la revendication 1 ou 2.

8. Procédé de préparation d'un mélange de luminophores selon la revendication 1 ou 2, dans lequel un premier luminophore à base de silicate est mélangé avec un ou plusieurs autres luminophores.
